# EUROPÄISCHE PATENTSCHRIFT

(11) **EP 2 954 337 B1**
(45) Veröffentlichungstag und Bekanntmachung des Hinweises auf die Patenterteilung: **26.02.2020**
(21) Anmeldenummer: 14701293.4
(22) Anmeldetag: 25.01.2014
(51) Int. Cl.: G01R 31/14, H02M 7/493, G01R 31/12, G01R 27/26

(54) **MOBILES HOCHSPANNUNGSPRÜFGERÄT**
MOBILE HIGH-VOLTAGE TESTER
CONTRÔLEUR MOBILE DE HAUTE TENSION

(30) Priorität: 08.02.2013 DE 102013002114
(43) Veröffentlichungstag der Anmeldung: 16.12.2015
(73) Patentinhaber: b2 electronics GmbH, 6833 Klaus (AT)
(72) Erfinder: BLANK, Rudolf, A-6832 Sulz (AT); BALDAUF, Stefan, A-6830 Rankweil (AT)
(74) Vertreter: Grättinger Möhring von Poschinger Patentanwälte Partnerschaft mbB
(86) Internationale Anmeldenummer: PCT/EP2014/000199
(87) Internationale Veröffentlichungsnummer: WO 2014/121900

(56) Entgegenhaltungen:
- EP-A2- 1 324 480
- WO-A2-2009/143543
- DE-A1- 3 737 373
- DE-A1-102007 034 558
- JP-A- 2006 200 898
- US-A1- 2011 267 854

## Beschreibung

Die vorliegende Erfindung betrifft ein mobiles Prüfgerät zur VLF-Prüfung eines Messobjekts, insbesondere eines Hoch- oder Mittelspannungskabels, umfassend Mittel zur Erzeugung einer als Prüfspannung dienenden Wechselspannung mit effektiver Amplitude größer gleich 1 kV und einer Frequenz im Bereich zwischen 0,01 und 1 Hz, ein Anschlusselement zum Anschluss des mit der Prüfspannung zu beaufschlagenden Messobjekts und Mittel zur Messung und Auswertung der an dem Messobjekt anliegenden Prüfspannung und des hierdurch verursachten Prüfstroms, wobei das Prüfgerät in einem ersten Betriebsmodus zur autonomen Durchführung einer VLF-Prüfung mit der von ihm erzeugten Prüfspannung eingerichtet ist. Ferner betrifft die vorliegende Erfindung ein System sowie ein Verfahren zur VLF-Prüfung eines Messobjekts.

Ein solches mobiles Prüfgerät ist aus der Patentanmeldung DE 10 2007 034 558 A1 bekannt, die die Präambel von Anspruch 1 offenbart.

Mobile (Hochspannungs-)Prüfgeräte der eingangs genannten Art sind aus dem Stand der Technik hinlänglich bekannt und dienen der sogenannten "Very Low Frequency"-Prüfung von Messobjekten, bei denen es sich um verschiedenste elektrische oder elektronische Bauteile oder insbesondere um Hoch- oder Mittelspannungskabel handeln kann. Bei der VLF-Prüfung wird das zu prüfende Messobjekt mit einer in der Regel sinusförmigen Wechselspannung mit einer Effektivspannung im kV-Bereich beaufschlagt und - unter Ermittlung und Auswertung der an dem Messobjekt anliegenden Prüfspannung und des hierdurch verursachten Prüfstroms - eine Aussage dahingehend getroffen, ob das geprüfte Messobjekt für einen vorgegebenen Zeitraum der Prüfspannung ohne Spannungsdurchschlag Stand gehalten hat. Im Falle einer sukzessiven Erhöhung der Prüfspannung kann dabei z.B. auch bestimmt werden, ab welcher Prüfspannung sicherheitsrelevante Spannungsdurchschläge stattfinden bzw. stattgefunden haben.

Ferner lässt sich mit besonders ausgestalteten VLF-Prüfgeräten der vorgenannten Art unter Auswertung der exakten Phasenverschiebung zwischen Prüfspannung und Prüfstrom auch der sogenannte Verlustfaktor (tan δ) des Messobjekts bestimmen, mit welchem im Rahmen einer zerstörungsfreien Prüfung z.B. eine Aussage zur Qualität bzw. zum Alterungszustand der Isolierung von Hoch- bzw. Mittelspannungskabeln getroffen werden kann. Die insoweit anzuwendenden Mess- und Auswertealgorithmen (und die hierfür notwendigen Mess- und Auswerteschaltungen) sind dem einschlägigen Fachmann hinlänglich bekannt.

Insbesondere im Falle der VLF-Prüfung von Hoch- oder Mittelspannungskabeln bestehen mit zunehmender Länge des zu prüfenden Kabels besonders hohe Anforderungen an die von gattungsgemäßen VLF-Prüfgeräten aufzubringende elektrische Leistung, wobei die Kosten von mobilen Prüfgeräten gattungsgemäßer Art mit zunehmender Ausgangsleistung stark steigen. In der Praxis werden daher mobile Prüfgeräte der eingangs genannten Art in verschiedenen Leistungsklassen angeboten, deren Einsatzmöglichkeiten - abhängig von der mit dem betreffenden Prüfgerät erzeugbaren Spannungsamplitude und der hierbei zur Verfügung stehenden Ausgangsleistung - beschränkt sind. Derzeit sind mobile VLF-Prüfgeräte mit Mitteln zur Erzeugung einer sinusförmigen VLF-Prüfspannung in einem Bereich von bis zu 200 kV Peak-Spannung (entsprechend ca. 141 kV Effektivspannung) bei elektrischen Ausgangsleistungen von bis zu ca. 8 kW verfügbar.

Im Lichte des vorstehend genannten Stands der Technik soll ein VLF-Prüfgerät sowie ein System und ein Verfahren der eingangs genannten Art zum Mehrwert der Anwender in funktionaler Hinsicht verbessert werden.

Diese Aufgabe wird mit einem mobilen Prüfgerät nach Anspruch 1 gelöst, welches sich neben den eingangs genannten Merkmalen dadurch auszeichnet, dass das Prüfgerät eine Kommunikationsschnittstelle zur Aussendung eines Synchronisierungssignals und/oder zum Empfang eines extern erzeugten Synchronisierungssignals aufweist und dass das Prüfgerät dazu eingerichtet ist, in einem zweiten Betriebsmodus (Parallelbetriebsmodus) die erzeugte Prüfspannung in Abhängigkeit von dem Synchronisierungssignal mit der von wenigstens einem weiteren Prüfgerät gleicher Art erzeugten Prüfspannung zu synchronisieren.

Ein erfindungsgemäßes mobiles Hochspannungsprüfgerät kann somit in hochflexibler Weise sowohl in einem ersten Betriebsmodus (Alleinbetrieb) zur vollkommen autonomen Durchführung einer VLF-Prüfung an einem Messobjekt verwendet werden als auch in einem zweiten Betriebsmodus (Parallelbetriebsmodus) parallel mit wenigstens einem zweiten mobilen Prüfgerät erfindungsgemäßer Art genutzt werden. Aufgrund der im Parallelbetriebsmodus vorgesehenen Prüfspannungssynchronisierung können dann wenigstens zwei erfindungsgemäße Prüfgeräte gleichzeitig zur VLF-Prüfung eines - an beide Prüfgeräte anzuschließenden - Messobjekts Verwendung finden. Dabei addieren sich die von den wenigstens zwei Prüfgeräten zur Verfügung gestellten Ausgangsleistungen auf.

Einem Anwender bzw. Käufer von erfindungsgemäßen Prüfgeräten wird somit die Möglichkeit gegeben, bei Bedarf wenigstens zwei oder mehrere erfindungsgemäße mobile Prüfgeräte gleichzeitig zur Durchführung einer VLF-Prüfung an ein und desselben Messobjekts einzusetzen, wodurch sich die für die VLF-Prüfung zur Verfügung stehende elektrische Leistung entsprechend der Anzahl der gleichzeitig im Parallelbetrieb verwendeten Geräte vervielfacht.

Beim Parallelbetrieb einer Mehrzahl erfindungsgemäßer Prüfgeräte können somit längere Hoch- bzw. Mittelspannungskabel einer VLF-Prüfung unterzogen werden als dies mit einem einzigen mobilen Prüfgerät gattungs- bzw. erfindungsgemäßer Art möglich ist.

Dabei ist im Rahmen der vorliegenden Erfindung gleichzeitig gewährleistet, dass jedes erfindungsgemäße Prüfgerät als solches nach wie vor zum Alleinbetrieb geeignet ist, wodurch z.B. ein Unternehmen, welches im Besitz mehrerer erfindungsgemäßer Prüfgeräte ist, entweder gleichzeitig an verschiedenen Orten verschiedene Messobjekte einer VLF-Prüfung mit je einem Prüfgerät unterziehen kann oder aber eine Mehrzahl an erfindungsgemäßen Prüfgeräten an einem Einsatzort bündeln kann, um dort ein Messobjekt, welches aufgrund eines besonders hohen Leistungsbedarfs für eine hieran durchzuführende VLF-Prüfung nicht mit einem einzigen Prüfgerät prüfbar wäre, unter gleichzeitiger Verwendung einer Mehrzahl an erfindungsgemäßen Prüfgeräten der gewünschten VLF-Prüfung mit der erforderlichen elektrischen Leistung zu unterziehen.

Im Rahmen eines solchen Prüf- bzw. Messvorgangs ist ersichtlich dafür Sorge zu tragen, dass das zu prüfende Messobjekt in einer Parallelschaltung an die hierfür vorgesehenen Anschlusselemente aller zur Verwendung kommenden mobilen Prüfgeräte angeschlossen wird. Die über ein Synchronisierungssignal erfolgende Synchronisierung der von allen erfindungsgemäßen Prüfgeräten erzeugten Prüfspannung gewährleistet die Bereitstellung einer geeigneten VLF-Prüfspannung bei gleichzeitiger Nutzung mehrerer Prüfgeräte, wobei im Parallelbetrieb mehrerer Prüfgeräte erfindungsgemäßer Art ersichtlich dafür Sorge getragen werden muss, dass alle Prüfgeräte die von ihnen erzeugte Prüfspannung anhand desselben Synchronisierungssignals auf dieselbe Art und Weise synchronisieren.

Selbstverständlich ist im Parallelbetrieb einer Mehrzahl von Prüfgeräten im Rahmen der Synchronisierung der von den einzelnen Prüfgeräten zu erzeugenden Wechselspannung dafür Sorge zu tragen, dass alle Prüfgeräte eine in ihrer Amplitude und Frequenz übereinstimmende Prüfspannung bereitstellen.

Bei der im Parallelbetrieb von den einzelnen Prüfgeräten bereitgestellten Wechselspannung kann es sich vorteilhaft um eine sinusförmige Wechselspannung, bevorzugt mit einer Frequenz von 0,1 Hz handeln, wobei prinzipiell auch andere Spannungsverläufe, wie z.B. eine Cosinus-Rechteck-Spannung, denkbar wären.

Im Falle einer sinusförmigen Wechselspannung gestaltet sich die erforderliche Synchronisierung mehrerer Prüfgeräte mittels eines Synchronisierungssignal jedoch als besonders einfach, während bei anderen Spannungsverläufen (z.B. cos-Rechteck) wegen dort auf schnelleren Zeitskalen erfolgenden Spannungsänderungen ggfs. deutlich höhere Anforderungen an die Synchronisierung zu stellen sind.

Die zur VLF-Prüfung benötigte Wechselspannung wird von einem erfindungsgemäßen Prüfgerät mit hierfür üblichen Mitteln und in üblicher Art und Weise bereitgestellt, z.B. durch geeignete Frequenzwandlung und Verstärkung einer an dem Prüfgerät über einen geeigneten Anschluss bereitgestellten Netzspannung, wobei prinzipiell auch ein Batteriebetrieb von erfindungsgemäßen Prüfgeräten denkbar ist, wie dies auch für gattungsgemäße VLF-Prüfgeräte bereits aus dem Stand der Technik bekannt ist.

Die vorliegende Erfindung kommt auch den wirtschaftlichen Interessen von Anwendern von VLF-Prüfgeräten entgegen, da diese somit nicht für gegebenenfalls nur selten durchzuführende VLF-Prüfungen von besonders langen Hoch- bzw. Mittelspannungskabeln ein einzelnes, besonders teures mobiles Prüfgerät gattungsgemäßer Art erwerben und vorhalten müssen. Vielmehr kann ein z.B. auf die Prüfung von Hoch- bzw. Mittelspannungskabeln spezialisiertes Unternehmen mit jeweils vergleichsweise geringem Investitionsbedarf sukzessive eine Mehrzahl an erfindungsgemäßen VLF-Prüfgeräten erwerben, die im gewöhnlichen Geschäftsbetrieb für typische Anwendungsfälle jeweils im Alleinbetrieb einsetzbar sind. Gleichzeitig wird das betreffende Unternehmen damit jedoch sukzessiv in die Lage versetzt, bei entsprechendem Bedarf auch längere Kabel einer VLF-Prüfung zu unterziehen. Von Vorteil ist insoweit auch, dass ein Anwender eines oder mehrerer erfindungsgemäßer Prüfgeräte durch Ausleihen bzw. Mieten wenigstens eines weiteren mobilen Prüfgeräts erfindungsgemäßer Art die ihm zur VLF-Prüfung zur Verfügung stehende elektrische Leistung für spezielle Messvorgänge erhöhen kann, so dass im Rahmen der vorliegenden Erfindung letztlich mit technischen Mitteln auch wirtschaftliche Vorteile für die Anwender von (erfindungsgemäßen) VLF-Prüfgeräten geschaffen werden.

Die vorliegende Erfindung betrifft ferner ein System zur VLF-Prüfung eines Messobjekts umfassend wenigstens zwei erfindungsgemäße mobile Prüfgeräte der vorstehend beschriebenen Art, wobei das System bei Betrieb aller Prüfgeräte im Parallelbetriebsmodus und geeignetem Anschluss des Messobjekts an alle Prüfgeräte dazu eingerichtet ist, dass die Prüfgeräte unter Synchronisierung der von ihnen jeweils erzeugten Wechselspannung zur VLF-Prüfung des Messobjekts derart zusammenwirken, dass das Messobjekt gleichzeitig mit den synchronisierten Wechselspannungen aller Prüfgeräte beaufschlagt wird.

Ersichtlich ist das zu prüfende Messobjekt hierfür mittels einer geeigneten Parallelschaltung an die Anschlusselemente der wenigstens zwei Prüfgeräte anzuschließen, so dass das Messobjekt gleichzeitig mit der synchronisierten Wechselspannung der wenigstens zwei im Parallelbetriebsmodus betriebenen Prüfgeräte beaufschlagt wird, wodurch sich im bereits weiter oben erläuterten Sinne die von allen Prüfgeräten des Systems bereitgestellte elektrische Leistung aufaddiert bzw. bei Prüfgeräten mit jeweils identischer Ausgangsleistung entsprechend vervielfacht.

Der guten Ordnung halber sei angemerkt, dass alle nachfolgend beschriebenen bevorzugten Weiterbildungen eines erfindungsgemäßen Systems selbstverständlich auch als bevorzugte Ausgestaltungen eines erfindungsgemäßen Prüfgeräts angesehen werden können, soweit sich diese auf die Prüfgeräte als solche bzw. deren Eigenschaften beziehen. Gleichermaßen gelten alle vorstehend erläuterten Aspekte und Vorteile eines erfindungsgemäßen Prüfgeräts selbstverständlich in gleicher Weise für ein erfindungsgemäßes System aus einer Mehrzahl (d.h. wenigstens zwei) an erfindungsgemäßen Prüfgeräten.

Bei Verwendung eines erfindungsgemäßen Systems kann bevorzugt wenigstens eines bzw. nochmals bevorzugt genau eines der im Parallelbetriebsmodus betriebenen Prüfgeräte zur Messung und Auswertung der am Messobjekt anliegenden Prüfspannung eingerichtet sein, wozu die auch im Alleinbetrieb des betreffenden Geräts verwendete Mess- und Auswerteschaltung eingesetzt werden kann. Eine (redundante) Messung der Prüfspannung durch mehrere bzw. alle Prüfgeräte kann ebenfalls erfolgen, macht jedoch letztlich wenig Sinn, da im Parallelbetrieb an jedem Prüfgerät die gleiche Prüfspannung anliegt.

Der aufgrund der VLF-Prüfspannung im Messobjekt (insgesamt) erzeugte elektrische Strom kann entweder direkt am Messobjekt, z.B. mittels einer separaten Strommesseinrichtung, gemessenen werden oder, wiederum bevorzugt, durch die in den einzelnen Prüfgeräten ohnehin bereits vorhandenen Mess- und Auswerteschaltungen ermittelt werden. Insoweit ergibt nämlich die Addition der in allen Prüfgeräten jeweils individuell gemessenen (Prüf-)Ströme den insgesamt im Messobjekt durch die Prüfspannung verursachten Strom, so dass in bevorzugter Weiterbildung des erfindungsgemäßen Systems vorgesehen ist, dass im Parallelbetriebsmodus alle Prüfgeräte zur Messung des durch die Prüfspannung in dem betreffenden Prüfgerät fließenden Prüfstroms eingerichtet sind.

Weiterhin kann in vorteilhafter Ausgestaltung des erfindungsgemäßen Systems vorgesehen sein, dass das System eine das Synchronisierungssignal erzeugende und aussendende (zentrale) Steuereinheit aufweist.

Dieses Synchronisierungssignal kann prinzipiell analog oder digital und kabelgebunden oder drahtlos übertragen werden, wobei im Rahmen der vorliegenden Erfindung letztlich nur dafür Sorge getragen werden muss, dass alle Prüfgeräte des Systems, welche das betreffende Signal über ihre hierfür vorgesehene Kommunikationsschnittstelle empfangen, in ihrem Parallelbetriebsmodus dazu eingerichtet sein müssen, die von ihnen erzeugte Wechselspannung in Abhängigkeit von dem Synchronisierungssignal auf geeignete Weise zu synchronisieren.

Von Vorteil ist ferner, wenn alle im Parallelbetriebsmodus betriebenen Prüfgeräte über eine (zentrale) Steuereinheit steuerbar sind, womit z.B. über die Steuereinheit - unter gleichzeitiger Aufrechterhaltung der Synchronisierung - die Spannungsamplitude der von allen Prüfgeräten erzeugten Prüfspannung synchron verändert werden könnte, z.B. um die von allen Prüfgeräten zu erzeugende Wechselspannung in ihrer Amplitude sukzessive und simultan bis zu einer Maximalspannung zu erhöhen. Bei digitalem Synchronisierungssignal enthält selbiges somit vorteilhaft nicht nur ein Taktsignal und ggfs. die Information zur konkret einzustellenden Frequenz, sondern auch eine Information zu der von den Prüfgeräten vorzugebenden Spannungsamplitude.

In einer abermals bevorzugten Weiterbildung des erfindungsgemäßen Systems ist vorgesehen, dass das System eine zentrale Auswerteeinheit aufweist, an welche alle zur Auswertung der VLF-Prüfung benötigten und von den verschiedenen Prüfgeräten im Parallelbetriebsmodus gemessenen Strom- und/oder Spannungswerte übertragen werden. Hierfür sollten ersichtlich alle Prüfgeräte des Systems über eine geeignete Schnittstelle verfügen, mit welcher sie die betreffenden Daten an die Auswerteeinheit - entweder drahtlos oder drahtgebunden - übermitteln können, wobei es sich bei besagter Schnittstelle ggfs. um die gleiche Kommunikationsschnittstelle handeln kann, mit welchen die einzelnen Prüfgeräte das Synchronisierungssignal empfangen (oder aussenden) können. Im Falle einer drahtgebundenen Signalübertragung sind die einzelnen Prüfgeräte bzw. deren (Kommunikations)Schnittstellen auf geeignete Weise mit der Steuereinheit und/oder der Auswerteeinheit bzw. untereinander zu verbinden.

Vorteilhaft ist die Steuereinheit und/oder die zentrale Auswerteeinheit in eines der Prüfgeräte oder in ein externes Gerät integriert. Im erstgenannten Fall kann dann z.B. das die Steuereinheit beinhaltende Prüfgerät das Synchronisierungssignal erzeugen und über seine Kommunikationsschnittstelle zum Empfang durch alle weiteren Prüfgeräte eines erfindungsgemäßen Systems aussenden, so dass das betreffende Prüfgerät gewissermaßen als "Master"-Prüfgerät fungiert. Dabei kann ein solches "Master"-Prüfgerät bevorzugt auch die zentrale Auswerteeinheit beinhalten, womit auch die zentrale Auswertung einer von mehreren Prüfgeräten gleichzeitig durchgeführten VLF-Prüfung durch das "Master"-Prüfgerät erfolgen kann.

In Bezug auf das erfindungsgemäß zur Spannungssynchronisierung vorgesehene Synchronisierungssignal kann im Übrigen vorgesehen sein, dass das Synchronisierungssignal während der Beaufschlagung des Messobjekts mit der (von allen Prüfgeräten erzeugten) Prüfspannung und der dabei stattfindenden VLF-Prüfung kontinuierlich bzw. iterativ wiederholt wird. Gleichfalls möglich ist allerdings auch die Verwendung eines - nur vor der eigentlichen Hochspannungsfreigabe bzw. VLF-Prüfung - ausgesandten Synchronisierungssignals, anhand dessen die zuvor in ihren Parallelbetriebsmodus geschalteten Prüfgeräte z.B. unter Verwendung einer geeigneten Timerfunktion gleichzeitig mit der Erzeugung einer Wechselspannung vorgegebener Amplitude und Frequenz beginnen können, so dass auch insoweit durch Vorgabe des Anfangszeitpunkts der Hochspannungserzeugung eine Synchronisierung im erfindungsgemäßen Sinne realisierbar ist.

Ein solches Synchronisierungssignal kann z.B. von einem in den Parallelbetriebsmodus geschalteten "Master"-Prüfgerät in Form einer Wechselspannung mit spezifischer Charakteristik mit den im Prüfgerät ohnehin vorhandenen Mitteln zur Erzeugung einer als Prüfspannung dienenden Wechselspannung erzeugt werden, wodurch besagte Mittel zur Erzeugung der Wechselspannung gleichzeitig als Kommunikationsschnittstelle zur Aussendung des Synchronisierungssignals dienen. Dieses Synchronisierungssignal kann dann durch die in den weiteren Prüfgeräten ebenfalls ohnehin vorhandenen Mittel zur Messung und Auswertung der an dem Messobjekt anliegenden Prüfspannung erkannt bzw. empfangen werden, so dass bei den weiteren Prüfgeräten die Mittel zur Messung und Auswertung der Prüfspannung dann gleichzeitig als Kommunikationsschnittstelle zum Empfang des externen Synchronisierungssignals dienen. Diese Ausführungsvariante hat den Vorteil, dass hierfür in den einzelnen Prüfgeräten keine zusätzliche Kommunikationsschnittstelle vorgesehen sein muss und dass zur drahtgebundenen Übertragung des Synchronisierungssignals die ohnehin zur Beaufschlagung des Messobjekts mit der Prüfspannung vorgesehene Leiter- bzw. Verteilerstruktur Verwendung finden kann, welche die einzelnen Prüfgeräte untereinander verbindet.

Ferner kann im Rahmen der vorliegenden Erfindung vorteilhaft vorgesehen sein, dass die (zentrale) Steuereinheit und/oder die zentrale Auswerteeinheit in ein externes Gerät, z.B. ein mobiles Datenverarbeitungsgerät, wie z.B. einen Laptop, integriert sind, da auch hierbei auf besonders einfache Weise eine zentrale Synchronisierung, Steuerung und/oder Auswertung der VLF-Prüfung möglich ist.

Wie bereits weiter oben ausgeführt, kann das Synchronisierungssignal vorteilhaft auch drahtlos übertragen werden, womit ersichtlich die zum Aussenden / Empfangen des Synchronisierungssignals vorgesehenen Kommunikationsschnittstellen der verschiedenen (Prüf-)Geräte zur drahtlosen Kommunikation eingerichtet sein müssen. Dabei kann die Kommunikation auf einem üblichen Standard zur drahtlosen Kommunikation basieren, bei dem es sich beispielsweise um Bluetooth, W-LAN oder sonstige Funk-Standards handeln kann. Insbesondere sei erwähnt, dass über die genannten Standards eine auch in zeitlicher Hinsicht hinreichend exakte Synchronisierung der von den Prüfgeräten zu erzeugenden Wechselspannung möglich ist, da diese eine Frequenz in einem Bereich von lediglich 0,01 bis 1 Hz, vorteilhaft 0,1 Hz, aufweist, womit eine Synchronisierung mit einer Genauigkeit im Millisekundenbereich durchaus ausreichend sein kann.

Im Rahmen der vorliegenden Erfindung kann dann in besonders vorteilhafter Weise dafür Sorge getragen sein, dass das System ausgehend von der gegebenen Anzahl von wenigstens zwei mobilen Prüfgeräten bis hin zu einer vorgegebenen Maximalzahl an Prüfgeräten um jeweils ein weiteres erfindungsgemäßes Prüfgerät erweiterbar ist, womit sich eine besonders flexibel an verschiedene Messsituationen anpassbare Systemgestaltung ergibt. Das erfindungsgemäße System lässt sich bequem um einzelne Prüfgeräte erweitern, bis die insgesamt zur Verfügung stehende elektrische Leistung für eine VLF-Prüfung an dem konkret zu prüfenden Messobjekt ausreichend ist.

In der Praxis kann die Maximalzahl der im Rahmen der vorliegenden Erfindung im Parallelbetrieb betreibbaren VLF-Prüfgeräte durch die konkrete Systemgestaltung z.B. auf eine Zahl im Bereich zwischen 10 und 25 Geräten beschränkt werden, so dass mit einem erfindungsgemäßen Systems bei Verwendung von VLF-Prüfgeräten mit Ausgangsleistungen von jeweils ca. 2 kW im Parallelbetriebsmodus von 10 - 25 Prüfgeräten bereits elektrische Leistungen von 20 - 50 kW zur Verfügung gestellt werden können.

Da das zu prüfende Messobjekt in einer Parallelschaltung stets an sämtliche Prüfgeräte eines erfindungsgemäßen Systems anzuschließen ist, ist es von Vorteil, wenn das System hierfür eine (vorgefertigte) Verteilerstruktur mit einer vorgegebenen Maximalzahl an hieran anschließbaren Prüfgeräten aufweist, welche die an den wenigstens zwei Prüfgeräten vorgesehenen Anschlusselemente für das Messobjekt und das zu prüfende Messobjekt in Art einer Parallelschaltung verbindet.

Weiterhin sollte im Rahmen der Erfindung in besonderes zweckmäßiger Weise dafür Sorge getragen sein, dass die wenigstens zwei Prüfgeräte mit einem gemeinsamen Erdpotential verbunden sind.

In einer abermals bevorzugten Weiterbildung des erfindungsgemäßen Systems ist schließlich vorgesehen, dass jedes Prüfgerät zur gleichzeitigen VLF-Prüfung von drei Phasen eines Hoch- oder Mittelspannungskabels mit derselben Prüfspannung eingerichtet ist, womit auch dreiphasige Hoch- und/oder Mittelspannungskabel in besonders zeitsparender Weise einer VLF-Prüfung unterzogen werden können.

Die vorliegende Erfindung betrifft außerdem ein Verfahren zur VLF-Prüfung eines Messobjekts unter Verwendung wenigstens zweier erfindungsgemäßer Prüfgeräte oder eines erfindungsgemäßen Systems der vorstehend beschriebenen Art umfassend die folgenden Schritte:
A) Verbinden des Messobjekts mit den jeweiligen Anschlusselementen aller Prüfgeräte mittels einer Parallelschaltung
B) Aktivieren des Parallelbetriebsmodus bei allen Prüfgeräten
C) Erzeugen und Aussenden eines Synchronisierungssignals
D) Gleichzeitiges Erzeugen einer anhand des Synchronisierungssignals synchronisierten Wechselspannung mit allen Prüfgeräten
E) Messen und Auswerten der am Messobjekt anliegenden Prüfspannung und des hierdurch im Messobjekt oder in den einzelnen Prüfgeräten verursachten Prüfstroms.

Es versteht sich von selbst, dass es dabei z.B. auf die Reihenfolge der Verfahrensschritte (B) und (C) nicht entscheidend ankommt und dass alle bereits weiter oben in Zusammenhang mit erfindungsgemäßen Prüfgeräten bzw. dem erfindungsgemäßen System erläuterten Vorteile und bevorzugten Ausgestaltungen, insbesondere im Hinblick auf deren Funktionsweise und Betrieb, gleichermaßen auf das erfindungsgemäße Verfahren übertragbar sind, so dass zur Vermeidung von Wiederholungen hierauf verwiesen wird.

Nachfolgend werden zwei Ausführungsbeispiele der Erfindung anhand der Zeichnung näher erläutert. Dabei zeigt
- Fig. 1: ein erstes Ausführungsbeispiel eines erfindungsgemäßen Systems umfassend insgesamt vier erfindungsgemäße Prüfgeräte und
- Fig. 2: ein zweites Ausführungsbeispiel eines erfindungsgemäßen Systems umfassend insgesamt vier erfindungsgemäße Prüfgeräte.

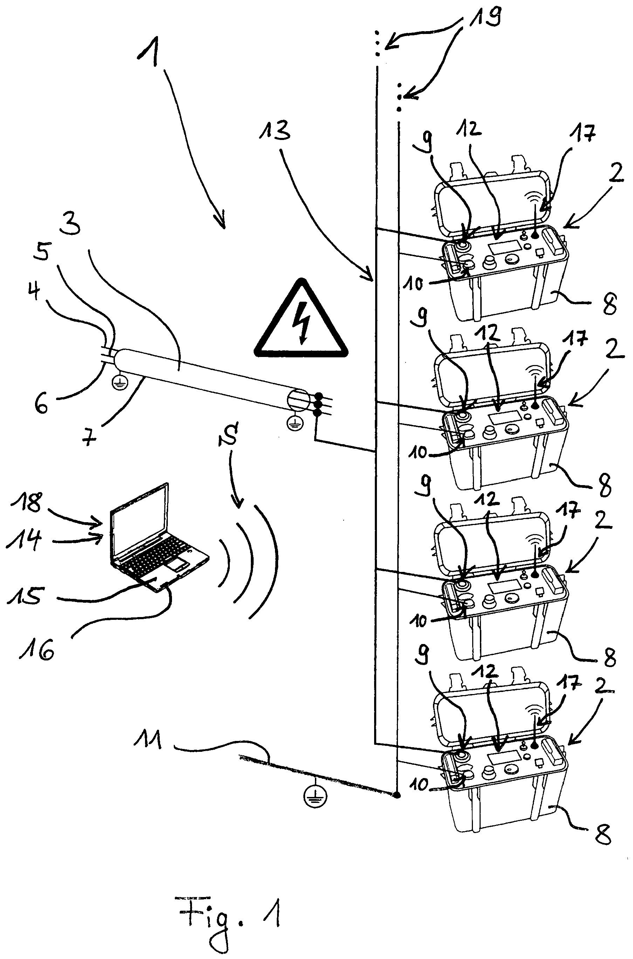

Fig. 1 zeigt in schematischer Weise ein erstes Ausführungsbeispiel eines erfindungsgemäßen Systems 1 umfassend vorliegend insgesamt vier erfindungsgemäße mobile Prüfgeräte 2 identischer Bauart zur VLF-Prüfung eines Messobjekt 3, vorliegend in Form eines geschirmten Hoch- bzw. Mittespannungskabels mit drei Phasen 4, 5, 6, dessen üblicherweise als Leitergeflecht ausgeführte Schirmung 7 geeignet an eine Schutzerde anzuschließen ist, auf deren Potential auch die Erdung für die Prüfgeräte 2 liegt.

Jedes der mobilen Prüfgeräte 2 weist in seinem Gehäuse 8 übliche - und in der Figur nicht dargestellte - Mittel zur Erzeugung einer als Prüfspannung dienenden Wechselspannung mit effektiver Amplitude größer gleich 1 kV und einer Frequenz im Bereich zwischen 0,01 und 1 Hz auf. Ferner ist an jedem Prüfgerät 2 ein Anschlusselement 9 zum Anschluss des mit der Prüfspannung zu beaufschlagenden Messobjekts 3 vorgesehen, wobei vorliegend jedes Prüfgerät 3 zur gleichzeitigen VLF-Prüfung aller drei Phasen 4, 5, 6 des Hoch- bzw. Mittelspannungskabels 3 mit derselben Prüfspannung eingerichtet ist.

Ferner weist jedes Prüfgerät 2 in seinem Gehäuse 8 übliche - und in der Figur ebenfalls nicht dargestellte - Mittel, nämlich eine geeignete Mess- und Auswerteschaltung, zur Messung und Auswertung der an dem Messobjekt 3 (bzw. dessen drei Phasen 4, 5, 6) anliegenden Prüfspannung und des hierdurch (innerhalb des Prüfgeräts 2) verursachten Prüfstroms auf.

Jedes Prüfgerät 2 weist ferner ein weiteres Anschlusselement 10 auf, über welches jedes Prüfgerät 2 geerdet bzw. alle Prüfgeräte 2 mit einem gemeinsamen Erdpotential 11 verbunden werden können.

Jedes der Prüfgeräte 2 ist in einem ersten Betriebsmodus zur vollkommen autonomen Durchführung einer VLF-Prüfung an einem Messobjekt 3 mit der von ihm erzeugten Prüfspannung eingerichtet, kann also im Alleinbetrieb unter Erzeugung einer vorzugsweise sinusförmigen VLF-Wechselspannung (Effektivspannung > 1kV; Frequenz zwischen 0,01 und 1 Hz, bevorzugt ca. 0,1 Hz) eine VLF-Prüfung üblicher Art, ggfs. auch in fachüblicher Weise eine Ermittlung des Verlustfaktors (tan delta), an einem an das Anschlusselement 9 des Prüfgeräts 2 angeschlossenen Messobjekts 3 durchführen.

Zur Steuerung des jeweiligen Prüfgeräts 2 im Alleinbetrieb bzw. zur Umschaltung des jeweiligen Prüfgeräts 2 zwischen erstem Betriebsmodus (Alleinbetrieb) und einem zweiten Betriebsmodus (Parallelbetriebsmodus) sowie zur Anzeige der bei einer VLF-Prüfung ermittelten Daten weist jedes Prüfgerät 2 in einem Bedienbereich 12 geeignete Anzeige- und Bedienelemente auf.

In der in der Figur dargestellten Anordnung, in welcher vorliegend das Messobjekt 3 in Parallelschaltung mittels einer schematisch dargestellten Verteilerstruktur 13 an die Anschlusselemente 9 aller vier Prüfgeräte 2 angeschlossen ist, sind die Prüfgeräte 2 alle in ihrem zweiten Betriebsmodus, nämlich dem Parallelbetriebsmodus zu betreiben.

Hierfür ist eine zentrale Steuereinheit 14 vorgesehen, welche in ein externes Gerät 15, vorliegend einen Laptop, integriert ist bzw. durch dieses gebildet wird. Die zentrale Steuereinheit 14 ist mit einer drahtlosen Kommunikationsschnittstelle 16, vorliegend einer in den Laptop 15 integrierten Bluetooth-Schnittstelle, ausgestattet, über welche ein von der zentralen Steuereinheit 14 erzeugtes Synchronisierungssignal S an sämtliche Prüfgeräte 2 des Systems 1 ausgesandt, welches als externes Synchronisierungssignal S von diesen an hierzu korrespondierenden Kommunikationsschnittstellen 17 der einzelnen Prüfgeräte 2 empfangen wird.

Die Prüfgeräte 2 und das Synchronisierungssignal S sind so ausgestaltet, dass jedes Prüfgerät 2 im Parallelbetriebsmodus die von ihm für eine VLF-Prüfung zu erzeugende Wechselspannung (vorzugsweise sinusförmig; Effektivspannung > 1kV; Frequenz zwischen 0,01 und 1 Hz, bevorzugt ca. 0,1 Hz) anhand des Synchronisierungssignals S hinsichtlich seiner Phasenlage (und vorteilhaft auch hinsichtlich seiner Frequenz und Spannungsamplitude, sofern diese nicht bereits seitens der einzelnen VLF-Prüfgeräte übereinstimmend vorgegeben sind) synchronisieren kann. Selbstverständlich könnte dabei auch eine kabelgebundene Übertragung des Synchronisierungssignals S erfolgen, wozu dann die einzelnen Prüfgeräte 2 über entsprechende Daten- bzw. Signalleitungen - ggfs. über einen nicht dargestellten Router - mit der zentralen Steuereinheit 14 zu verbinden wären.

Eine im Parallelbetrieb der Prüfgeräte 2 erfolgende VLF-Prüfung geht dann so vonstatten, dass nach Umschalten aller Prüfgeräte 2 in den Parallelbetriebsmodus und Herstellung des Anschlusses des Messobjekts 3 an alle Prüfgeräte 2 in der dargestellten Parallelschaltung, alle Prüfgeräte 2 eine anhand des Synchronisierungssignals S und somit untereinander synchronisierte VLF-Wechselspannung bereitstellen, so dass das Messobjekt 3 gleichzeitig von der (synchronisierten) Prüfspannung aller Prüfgeräte 2 beaufschlagt wird, wobei während der dann erfolgenden VLF-Prüfung wenigstens ein Prüfgerät 2 die dabei am Messobjekt 3 anliegende Prüfspannung ermittelt und alle Prüfgeräte 2 die aufgrund der Prüfspannung in dem jeweiligen Prüfgerät 2 erzeugten bzw. fließenden Prüfströme ermittelt. Eine vor der eigentlichen VLF-Prüfung üblicherweise stattfindende Lastermittlung, anhand derer z.B. Regelparameter für die eigentliche VLF-Prüfung bestimmt werden können, kann im Rahmen der Erfindung zunächst von einem einzigen der Prüfgeräte 2 durchgeführt werden.

Die bei der VLF-Prüfung gewonnen Messdaten zur Prüfspannung und den von den jeweiligen Prüfgeräten ermittelten Prüfströmen können sodann über die jeweilige Kommunikationsschnittstelle 17, die hierfür bidirektional ausgestaltet ist, an die gleichzeitig als zentrale Auswerteeinheit 18 fungierende zentrale Steuereinheit 14 übermittelt werden, welches unter Auswertung der Messdaten in üblicher Weise etwaige Spannungsdurchschläge im Messobjekt 3 erkennt und ggfs. eine Ermittlung des Verlustfaktors des Messobjekts 3 durchführt.

Das Ergebnis der VLF-Prüfung, welches sich aus der gemessenen Prüfspannung und den addierten Prüfströmen ableiten lässt, kann dann von der zentralen Auswerteeinheit 18 auf geeignete Weise dargestellt oder ausgegeben werden.

Die punktierte Fortsetzung der schematisch dargestellten Verteilerstruktur 13 zur Verbindung der Prüfgeräte 2 mit dem Messobjekt 3, welche vorliegend auch zur gemeinsamem Erdung aller Prüfgeräte dient, deutet an, dass das erfindungsgemäße System 1 derart eingerichtet ist, dass es in einfacher Weise, d.h. durch bloßen Anschluss je eines weiteren in den Parallelbetriebsmodus zu schaltenden Prüfgeräts 2, um jeweils ein weiteres Prüfgerät 2 erweiterbar ist, wobei durch geeignete Gestaltung der Software der zentralen Steuereinheit 14 eine automatische Erkennung aller hierüber zu steuernder Prüfgeräte realisierbar ist. In der Praxis macht es Sinn, die Maximalzahl der hierbei in einem System 1 auf erfindungsgemäße Weise zusammenschaltbaren Prüfgeräte 2 auf z.B. 10, 15, 20 oder 25 Prüfgeräte 2 zu beschränken.

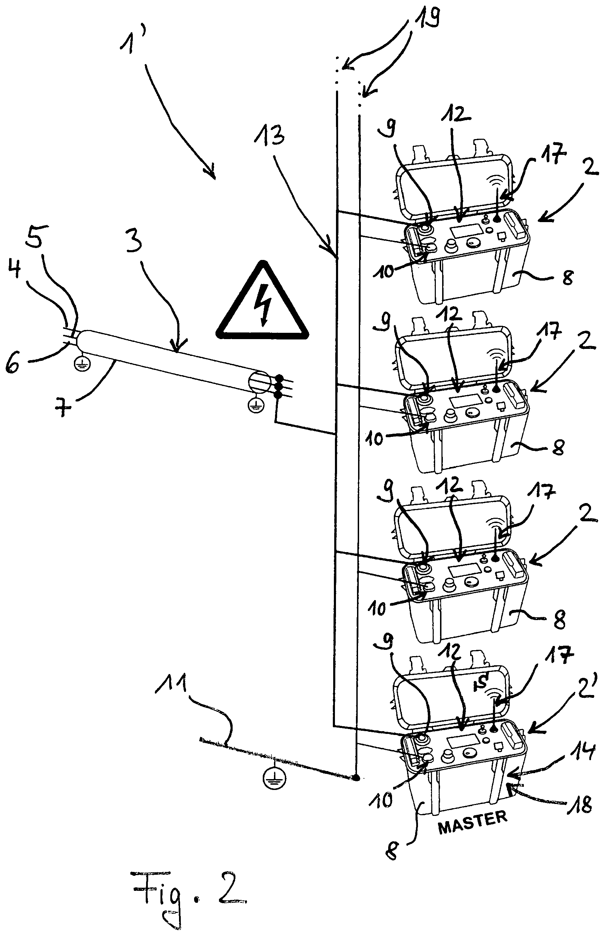

Fig. 2 zeigt ein zweites Ausführungsbeispiel eines erfindungsgemäßen Systems 1' aus wiederum insgesamt vier erfindungsgemäßen Prüfgeräten 2, 2', welches sich in vielerlei Hinsicht nicht von demjenigen aus Fig. 1 unterscheidet, so dass bezüglich übereinstimmender Aspekte zur Vermeidung von Wiederholungen auf die vorstehenden Ausführungen in Zusammenhang mit Fig. 1 verwiesen wird.

Der Unterschied zu dem System 1 aus Fig. 1 besteht darin, dass bei dem System 1' aus Fig. 2 die das Synchronisierungssignal S erzeugende zentrale Steuereinheit 14 wie auch die zentrale Auswerteeinheit 18 nicht in ein externes Gerät, sondern in eines der Prüfgeräte 2, nämlich das in Fig. 2 rechts unten dargestellte Prüfgerät 2' integriert ist. Bei diesem als "Master" bezeichneten Prüfgerät 2' ist somit dessen Kommunikationsschnittstelle 17 zum Aussenden des Synchronisierungssignals S eingerichtet, welches dann als externes Signal von allen weiteren Prüfgeräten 2 des Systems 1' über deren jeweilige Kommunikationsschnittstelle 17 empfangen wird.

Über die ebenfalls in das "Master"-Prüfgerät 2' integrierte Auswerteeinheit 18 können dann die Messdaten zu Prüfspannung und Prüfströmen sämtlicher Prüfgeräte 2, 2' in üblicher Weise ausgewertet oder ggfs. an (nicht dargestelltes) externes Gerät (z.B. einen Laptop) weitergeleitet werden.

Hierbei werden an der (bidirektionalen) Kommunikationsschnittstelle 17 des Master-Prüfgeräts die von den anderen Prüfgeräten 2 über deren (bidirektionale) Kommunikationsschnittstelle 17 übermittelten Messdaten empfangen, was durch Verwendung eines geeigneten Kommunikationsprotokolls ermöglicht wird.

## Patentansprüche

1. Mobiles Prüfgerät (2, 2') zur VLF-Prüfung eines Messobjekts (3), insbesondere eines Hoch- oder Mittelspannungskabels, umfassend
- Mittel zur Erzeugung einer als Prüfspannung dienenden Wechselspannung mit effektiver Amplitude größer gleich 1 kV und einer Frequenz im Bereich zwischen 0,01 und 1 Hz,
- ein Anschlusselement (9) zum Anschluss des mit der Prüfspannung zu beaufschlagenden Messobjekts (3) und
- Mittel zur Messung und Auswertung der an dem Messobjekt anliegenden Prüfspannung und des hierdurch verursachten Prüfstroms,
wobei das Prüfgerät (2, 2') in einem ersten Betriebsmodus zur autonomen Durchführung einer VLF-Prüfung mit der von ihm erzeugten Prüfspannung eingerichtet ist,
**dadurch gekennzeichnet,**
**dass** das Prüfgerät (2, 2') außerdem eine Kommunikationsschnittstelle (17) zur Aussendung eines Synchronisierungssignals (S) und/oder zum Empfang eines extern erzeugten Synchronisierungssignals (S) aufweist und
**dass** das Prüfgerät (2, 2') dazu eingerichtet ist, in einem zweiten Betriebsmodus, dem Parallelbetriebsmodus, die erzeugte Prüfspannung in Abhängigkeit von dem Synchronisierungssignal (S) mit der von wenigstens einem weiteren Prüfgerät (2, 2') gleicher Art erzeugten Prüfspannung zu synchronisieren.

2. System (1, 1') zur VLF-Prüfung eines Messobjekts (3) umfassend wenigstens zwei mobile Prüfgeräte (2, 2') nach Anspruch 1,
wobei das System (1, 1')bei Betrieb aller Prüfgeräte (2, 2') im Parallelbetriebsmodus und geeignetem Anschluss des Messobjekts (3) an alle Prüfgeräte (2, 2') dazu eingerichtet ist, dass die Prüfgeräte (2, 2') unter Synchronisierung der von ihnen jeweils erzeugten Wechselspannung zur VLF-Prüfung des Messobjekts (3) derart zusammenwirken, dass das Messobjekt (3) gleichzeitig mit den synchronisierten Wechselspannungen aller Prüfgeräte (2, 2') beaufschlagt wird.

3. System nach Anspruch 2,
**dadurch gekennzeichnet,**
**dass** wenigstens eines der im Parallelbetriebsmodus betriebenen Prüfgeräte (2, 2') zur Messung der am Messobjekt anliegenden Prüfspannung eingerichtet ist und
**dass** im Parallelbetriebsmodus alle Prüfgeräte (2, 2') zur Messung des durch die Prüfspannung in dem betreffenden Prüfgerät (2, 2') fließenden Prüfstroms eingerichtet sind.

4. System nach Anspruch 2 oder 3,
**dadurch gekennzeichnet,**
**dass** das System (1, 1') eine das Synchronisierungssignal erzeugende und aussendende Steuereinheit (14) aufweist.

5. System nach Anspruch 4,
**dadurch gekennzeichnet,**
**dass** alle im Parallelbetriebsmodus betriebenen Prüfgeräte (2, 2') über die Steuereinheit (14) steuerbar sind.

6. System nach einem der Ansprüche 2 - 5,
**dadurch gekennzeichnet,**
**dass** das System eine zentrale Auswerteeinheit (18) aufweist, an welche alle zur Auswertung der VLF-Prüfung benötigten und von den verschiedenen Prüfgeräten (2, 2') im Parallelbetriebsmodus gemessenen Strom- und/oder Spannungswerte übertragen werden.

7. System nach einem der Ansprüche 4 - 6,
**dadurch gekennzeichnet,**
**dass** die Steuereinheit (14) und/oder die zentrale Auswerteeinheit (18) in eines der Prüfgeräte (2') oder in ein externes Gerät (15) integriert ist.

8. System nach einem der Ansprüche 2 - 7,
**dadurch gekennzeichnet,**
**dass** das Synchronisierungssignal (S) drahtlos übermittelt wird.

9. System nach einem der Ansprüche 2 - 8,
**dadurch gekennzeichnet,**
**dass** das System (1, 1') ausgehend von der gegebenen Anzahl von wenigstens zwei mobilen Prüfgeräten (2, 2') bis hin zu einer vorgegebenen Maximalzahl an Prüfgeräten (2, 2') um jeweils ein weiteres Prüfgerät (2)nach Anspruch 1 erweiterbar ist.

10. System nach einem der Ansprüche 2 - 9,
**dadurch gekennzeichnet,**
**dass** das System (1, 1') eine Verteilerstruktur (13) mit einer vorgegebenen Maximalzahl an hieran anschließbaren Prüfgeräten (2, 2') aufweist, welche die an den wenigstens zwei Prüfgeräten (2, 2') vorgesehenen Anschlusselemente (9) für das Messobjekt (3) und das zu prüfende Messobjekt (3) in Art einer Parallelschaltung verbindet.

11. System nach einem der Ansprüche 2 - 10,
**dadurch gekennzeichnet,**
**dass** die wenigstens zwei Prüfgeräte (2, 2') mit einem gemeinsamen Erdpotential (11) verbunden sind.

12. System nach einem der Ansprüche 2 - 11,
**dadurch gekennzeichnet,**
**dass** jedes Prüfgerät (2, 2') zur gleichzeitigen VLF-Prüfung von drei Phasen (4, 5, 6) eines Hoch-oder Mittelspannungskabels (3) mit derselben Prüfspannung eingerichtet ist.

13. Verfahren zur VLF-Prüfung eines Messobjekts (3) unter Verwendung wenigstens zweier mobiler Prüfgeräte (2, 2') gemäß Anspruch 1 oder eines Systems (1, 1') gemäß einem der Ansprüche 2 - 12 umfassend die folgenden Schritte:
A) Verbinden des Messobjekts (3) mit den jeweiligen Anschlusselementen (9) aller Prüfgeräte (2, 2') mittels einer Parallelschaltung
B) Aktivieren des Parallelbetriebsmodus bei allen Prüfgeräten (2, 2')
C) Erzeugen und Aussenden eines Synchronisierungssignals (S)
D) Gleichzeitiges Erzeugen einer anhand des Synchronisierungssignals (S) synchronisierten Prüfspannung mit allen Prüfgeräten (2, 2')
E) Messen und Auswerten der am Messobjekt (3) anliegenden Prüfspannung und des hierdurch im Messobjekt (3) oder in den einzelnen Prüfgeräten (2) verursachten Prüfstroms.

## Claims

1. A mobile tester (2, 2') for VLF testing of a measurement object (3), especially a high-voltage or medium-voltage cable, comprising
- means for generating an a.c. voltage, used as the test voltage, with rms amplitude greater than or equal to 1 kV and a frequency in the range between 0.01 and 1 Hz,
- a terminal element (9) for connection of the measurement object (3) to be subjected to the test voltage and
- means for measurement and evaluation of the test voltage present at the measurement object and of the test current caused hereby,
wherein the tester (2, 2') is set up in a first mode of operation for autonomous performance of a VLF test with the test voltage generated by it,
**characterized**
**in that** the tester (2, 2') additionally has a communications interface (17) for transmitting a synchronization signal (S) and/or for receiving an externally generated synchronization signal (S) and
**in that** the tester (2, 2') is set up, in a second mode of operation, the parallel mode, to synchronize the generated test voltage as a function of the synchronization signal (S) with the test voltage generated by at least one further tester (2, 2') of the same type.

2. A system (1, 1') for VLF testing of a measurement object (3), which system comprises at least two mobile testers (2, 2') according to claim 1,
wherein the system (1, 1') is set up, during operation of all testers (2, 2') in parallel mode and suitable connection of the measurement object (3) to all testers (2, 2'), to ensure that the testers (2, 2') interact with one another through synchronization of the a.c. voltage generated respectively by them for the VLF test of the measurement object (3) in such a way that the measurement object (3) is subjected simultaneously to the synchronized a.c. voltages of all testers (2, 2').

3. A system according to claim 2,
**characterized**
**in that** at least one of the testers (2, 2') operated in parallel mode is set up for measurement of the test voltage present at the measurement object and
**in that**, in parallel mode of operation, all testers (2, 2') are set up for measurement of the test current flowing in the tester (2, 2') in question due to the test voltage.

4. A system according to claim 2 or 3,
**characterized**
**in that** the system (1, 1') has a control unit (14) that generates and transmits the synchronization signal.

5. A system according to claim 4,
**characterized**
**in that** all testers (2, 2') operated in parallel mode can be controlled via the control unit (14).

6. A system according to one of claims 2 - 5,
**characterized**
**in that** the system has a central evaluation unit (18), to which all voltage and/or current values needed for evaluation of the VLF test and measured by the various testers (2, 2') in parallel mode are transmitted.

7. A system according to one of claims 4 - 6,
**characterized**
**in that** the control unit (14) and/or the central evaluation unit (18) is/are integrated into one of the testers (2') or into an external device (15).

8. A system according to one of claims 2 - 7,
**characterized**
**in that** the synchronization signal (S) is transmitted in wireless form.

9. A system according to one of claims 2 - 8,
**characterized**
**in that**, starting from the specified number of at least two mobile testers (2, 2'), the system (1, 1') can be expanded respectively by one further tester (2) according to claim 1 up to a given maximum number of testers (2, 2').

10. A system according to one of claims 2 - 9,
**characterized**
**in that** the system (1, 1') is provided with a distributor structure (13), which has a specified maximum number of testers (2, 2') capable of being connected thereto and which connects the terminal elements (9) provided for the measurement object (3) on the at least two testers (2, 2') and the measurement object (3) to be tested in the manner of a parallel circuit.

11. A system according to one of claims 2 - 10,
**characterized**
**in that** the at least two testers (2, 2') are connected to a common ground potential (11).

12. A system according to one of claims 2 - 11,
**characterized**
**in that** each tester (2, 2') is set up for simultaneous VLF testing of three phases (4, 5, 6) of a high-voltage or medium-voltage cable (3) with the same test voltage.

13. A method for VLF testing of a measurement object (3) using at least two mobile testers (2, 2') according to claim 1 or a system (1, 1') according to one of claims 2 - 12 comprising the following steps:
A) Connecting the measurement object (3) to the respective terminal elements (9) of all testers (2, 2') by means of a parallel circuit
B) Activating the parallel mode in all testers (2, 2')
C) Generating and transmitting a synchronization signal (S)
D) Simultaneously generating, with all testers (2, 2'), a test voltage synchronized on the basis of the synchronization signal (S)
E) Measuring and evaluating the test voltage present at the measurement object (3) and the test current caused hereby in the measurement object (3) or in the individual testers (2).

## Revendications

1. Testeur mobile (2, 2') permettant d'effectuer un test VLF sur un objet à mesurer (3), en particulier un câble à haute ou moyenne tension, comprenant :
- des moyens destinés à produire une tension alternative servant de tension de test, avec une amplitude effective supérieure ou égale à 1 kV et une fréquence comprise entre 0,01 et 1 Hz,
- un élément de raccordement (9) pour le raccordement de l'objet à mesurer (3) soumis à la tension de test, et
- des moyens destinés à mesurer et évaluer la tension de test appliquée à l'objet à mesurer et le courant de test ainsi généré,
dans lequel, dans un premier mode de fonctionnement, le testeur (2, 2') est conçu pour exécuter un test VLF de façon autonome avec une tension de test produite par celui-ci,
**caractérisé en ce que**
le testeur (2, 2') présente également une interface de communication (17) destinée à émettre un signal de synchronisation (S) et/ou à recevoir un signal de synchronisation (S) produit extérieurement, et
**en ce que** dans un deuxième mode de fonctionnement, le mode de fonctionnement en parallèle, le testeur (2, 2') est conçu pour synchroniser la tension de test produite avec la tension de test produite par au moins un autre testeur (2, 2') similaire, en fonction du signal de synchronisation (S).

2. Système (1, 1') destiné à effectuer un test VLF sur un objet à mesurer (3), comprenant au moins deux testeurs mobiles (2, 2') selon la revendication 1,
dans lequel, lorsque tous les testeurs (2, 2') fonctionnement dans le mode de fonctionnement en parallèle et que l'objet à mesurer (3) est raccordé de façon appropriée à tous les testeurs (2, 2'), le système (1, 1') est conçu de manière à ce que les testeurs (2, 2') coopèrent par synchronisation de leur tension alternative respectivement produite par eux pour effectuer un test VLF de l'objet à mesurer (3), de telle façon que l'objet à mesurer (3) est soumis simultanément aux tensions alternatives synchronisées de tous les testeurs (2, 2').

3. Système selon la revendication 2,
**caractérisé en ce que**
l'un au moins des testeurs (2, 2') fonctionnant dans le mode de fonctionnement en parallèle est conçu pour mesurer la tension de test appliquée à l'objet à mesurer, et
**en ce que** dans le mode de fonctionnement en parallèle, tous les testeurs (2, 2') sont conçus pour mesurer le courant de test circulant dans le testeur (2, 2') concerné du fait de la tension de test.

4. Système selon la revendication 2 ou 3,
**caractérisé en ce que**
le système (1, 1') présente une unité de commande (14) produisant et émettant le signal de synchronisation.

5. Système selon la revendication 4,
**caractérisé en ce que**
tous les testeurs (2, 2') fonctionnant dans le mode de fonctionnement en parallèle peuvent être commandés par le biais de l'unité de commande (14).

6. Système selon l'une des revendications 2 à 5,
**caractérisé en ce que**
le système présente une unité d'évaluation centrale (18) à laquelle sont transmises toutes les valeurs de courant et/ou de tension mesurées par les différents testeurs (2, 2') dans le mode de fonctionnement en parallèle et nécessaires à l'évaluation du test VLF.

7. Système selon l'une des revendications 4 à 6,
**caractérisé en ce que**
l'unité de commande (14) et/ou l'unité d'évaluation centrale (18) est/sont intégrée(s) dans l'un des testeurs (2') ou dans un appareil externe (15).

8. Système selon l'une des revendications 2 à 7,
**caractérisé en ce que**
le signal de synchronisation (S) est transmis sans fil.

9. Système selon l'une des revendications 2 à 8,
**caractérisé en ce que**
le système (1, 1') peut être étendu respectivement à un testeur (2) selon la revendication 1 supplémentaire par rapport au nombre donné d'au moins deux testeurs mobiles (2, 2'), jusqu'à un nombre maximum prédéfini de testeurs (2, 2').

10. Système selon l'une des revendications 2 à 9,
**caractérisé en ce que**
le système (1, 1') présente une structure de distribution (13) avec un nombre maximum prédéfini de testeurs (2, 2') aptes à être raccordés à celle-ci, laquelle relie les éléments de raccordement (9) prévus sur les au moins deux testeurs (2, 2') pour l'objet à mesurer (3) et l'objet à mesurer (3) à tester selon un montage en parallèle.

11. Système selon l'une des revendications 2 à 10,
**caractérisé en ce que**
les au moins deux testeurs (2, 2') sont reliés à un potentiel de masse commun (11).

12. Système selon l'une des revendications 2 à 11,
**caractérisé en ce que**
chaque testeur (2, 2') est conçu pour effectuer un test VLF simultané sur trois phases (4, 5, 6) d'un câble à haute ou moyenne tension (3) avec la même tension de test.

13. Procédé pour l'exécution d'un test VLF sur un objet à mesurer (3) à l'aide d'au moins deux testeurs mobiles (2, 2') selon la revendication 1 ou d'un système (1, 1') selon l'une des revendications 2 à 12, comprenant les étapes suivantes :
A) raccordement de l'objet à mesurer (3) aux éléments de raccordement (9) respectifs de tous les testeurs (2, 2') à l'aide d'un montage en parallèle
B) activation du mode de fonctionnement en parallèle pour tous les testeurs (2, 2'),
C) production et émission d'un signal de synchronisation (S),
D) production simultanée d'une tension de test synchronisée à l'aide du signal de synchronisation (S) avec tous les testeurs (2, 2'),
E) mesure et évaluation de la tension de test appliquée à l'objet à mesurer (3) et du courant de test ainsi généré dans l'objet à mesurer (3) ou dans les différents testeurs (2).
